# EUROPEAN PATENT APPLICATION

(11) **EP 4 534 965 A1**
(43) Date of publication of application: **09.04.2025**
(21) Application number: 24197548.1
(22) Date of filing: 30.08.2024
(51) Int. Cl.: G01K 1/08, F27D 21/00, G01K 1/10

(54) **TEMPERATURE MEASUREMENT ASSEMBLY, SUBSTRATE PROCESSING APPARATUS, METHOD OF PROCESSING SUBSTRATE, AND METHOD OF MANUFACTURING SEMICONDUCTOR DEVICE**

(30) Priority: 06.10.2023 JP 2023174639
(71) Applicant: Kokusai Electric Corporation, Tokyo 101-0045 (JP)
(72) Inventor: AKAO, Tokunobu, Toyama-shi, Toyama, 9392393 (JP); TANIGUCHI, Daiki, Toyama-shi, Toyama, 9392393 (JP)
(74) Representative: Bardehle Pagenberg Partnerschaft mbB Patentanwälte Rechtsanwälte

(57) **Abstract**

There is provided a technique that enables stable temperature measurement for a long period under a high-temperature environment. It includes (a) an insulating tube (37) with two through-holes (37a), through which two conductive wires (32a) of a temperature sensor (32) are respectively inserted, (b) a first protective tube (33), through which the insulating tube (37) is inserted inwardly from a first end thereof, (c) a cylindrical sleeve (35, 135) airtightly connected to the first end of the first protective tube (33) and airtightly installed to an installation port (41, 141) from an outside of a furnace (2), and (d) a second protective tube (34) mounted to the installation port (41, 141) from a furnace (2) and covering the entire first protective tube (33) on the inside of the furnace (2).

## Description

### CROSS-REFERENCE TO RELATED APPLICATION

This application is based upon and claims the benefit of priority from Japanese Patent Application No. 2023-174639, filed on October 6, 2023, the entire contents of which are incorporated herein by reference.

### TECHNICAL FIELD

The present disclosure relates to a temperature measurement assembly, a substrate processing apparatus, a method of processing a substrate, and a method of manufacturing a semiconductor device.

### BACKGROUND

In a method of manufacturing a semiconductor device, there are cases where a vertical substrate processing apparatus is used as an apparatus for forming or annealing a film such as an oxide film on a substrate (hereinafter referred to as "wafer"). When performing this processing on the wafer, the interior of a process chamber is heated to a predetermined temperature while a process gas is supplied to the interior of the process chamber. To maintain the interior of the process chamber at a predetermined temperature, a temperature sensor for detecting the temperature, such as a thermocouple, may be provided in the interior of the process chamber.

### SUMMARY

Some embodiments of the present disclosure provide a technique capable of allowing stable temperature measurement for a long period under a high-temperature environment.

According to one embodiment of the present disclosure, there is provided a technique including (a) an insulating tube with two through-holes, through which two conductive wires of a temperature sensor are respectively inserted, (b) a first protective tube, through which the insulating tube is inserted inwardly from a first end of the first protective tube, (c) a cylindrical sleeve airtightly connected to the first end of the first protective tube and airtightly installed to an installation port from an outside of a furnace, and (d) a second protective tube mounted to the installation port from an inside of the furnace and covering the entire first protective tube on the inside of the furnace.

### BRIEF DESCRIPTION OF DRAWINGS

The accompanying drawings, which are incorporated in and constitute a part of the specification, illustrate embodiments of the present disclosure.
FIG. 1 is a longitudinal cross-sectional view of a process furnace according to one embodiment of the present disclosure.
FIG. 2 is a cross-sectional view along the central axis of a temperature measurement assembly installed according to one embodiment.
FIG. 3 is a bottom view of a horizontal cross-section of the temperature measurement assembly within a process furnace 2 according to one embodiment.
FIG. 4 is a bottom view of a first insulating tube according to one embodiment.
FIG. 5 is a perspective view looking up from the lower left side of a vertical cross-section near a T-joint of the temperature measurement assembly according to one embodiment.
FIG. 6 is a flowchart illustrating a method of processing a substrate according to one embodiment.
FIG. 7A is a cross-sectional view along the central axis of a temperature measurement assembly according to a modification of the present disclosure, and FIG. 7B is a bottom view of a sleeve of the temperature measurement assembly illustrated in FIG. 7A.

### DETAILED DESCRIPTION

Reference is now made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

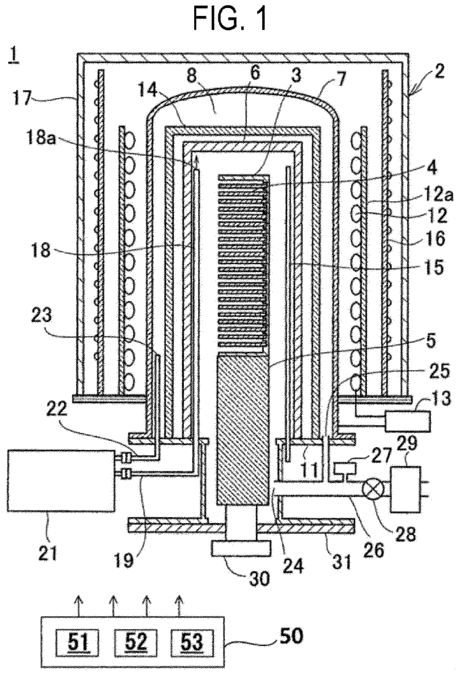

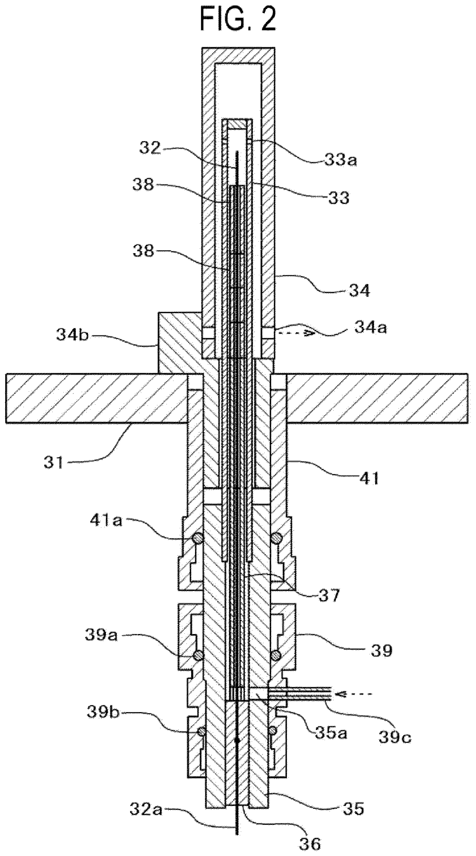

Hereinafter, one embodiment of the present disclosure will be described mainly with reference to FIGS. 1 to 5. In addition, the drawings used in the following description are all schematic, and a relationship between the dimensions of respective elements, the ratios of respective elements, etc. illustrated in the drawings do not necessarily correspond to the reality. Further, the dimensional relationships between respective elements and the proportions of respective elements may not necessarily match between multiple drawings. In addition, the same reference numerals are given to elements that are substantially the same as those described in FIGS. 1 and 2 and descriptions thereof are omitted. Furthermore, unless otherwise mentioned in the specification, each element is not limited to one and may be present in plurality.

FIG. 1 illustrates a vertical cross-sectional view of a process furnace 2 in a substrate processing apparatus 1 according to the present embodiment. The substrate processing apparatus 1 is configured as a batch-type vertical annealing apparatus that performs annealing treatment on a plurality of vertically aligned silicon carbide (SiC) substrates. Configuring it as a batch-type processing apparatus allows a great number of substrates to be processed at once, thereby improving productivity.

The substrate processing apparatus 1 includes the process furnace 2, and a boat 3, which serves as a substrate holder, is separably inserted into the process furnace 2. The boat 3 is made of, for example, a heat-resistant material such as carbon graphite or SiC. The boat 3 is configured to hold a plurality of wafers 4, which serve as substrates made of SiC or other materials, in such a state that the wafers 4 are arranged in a horizontal posture and are stacked along a vertical direction with the centers of the wafers 4 aligned with one another.

A thermal-insulator 5, which serves as a thermal-insulator made of, for example, a heat-resistant material such as SiC, is arranged below the boat 3. The thermal-insulator 5 is configured to support the boat 3 from below, making it difficult for heat from a heat-generator 6 to be described later to be transferred downward of the process furnace 2. When the boat 3 charged with the plurality of wafers 4 is loaded into the process furnace 2, a thermal-process is performed.

As illustrated in FIG. 1, the process furnace 2 includes a reaction tube 7, which is made of a heat-resistant material such as quartz or SiC and which is formed in a cylindrical shape with a closed upper end and an open lower end. A reaction chamber 8, which serves as a process chamber, is formed in a cylindrical hollow portion of the reaction tube 7. The reaction chamber 8 is configured to accommodate therein the above-described boat 3, which holds the wafers 4 serving as substrates made of SiC or other materials.

A manifold 11 is arranged concentrically with the reaction tube 7 below the reaction tube 7. The manifold 11 is made of a metal, for example, and is formed in a cylindrical shape with open upper and lower ends. The manifold 11 is provided to support the reaction tube 7 from below. An O-ring (not illustrated), which serves as a sealing member, is provided between the manifold 11 and the reaction tube 7. A reaction container is formed by the reaction tube 7 and the manifold 11.

The process furnace 2 includes the heat-generator 6, which serves as a heating target to be inductively heated, and an inductive coil 12, which serves as an inductive heater, i.e., a magnetic-field generator. The heat-generator 6 is formed in a cylindrical shape using, for example, a conductive heat-resistant material such as carbon, and is provided to surround the boat 3 accommodated in the reaction chamber 8, i.e., to surround an accommodation region for the wafers 4. The heat-generator 6 may be formed in a cylindrical shape with open upper and lower ends, or may be formed in a cylindrical shape with a closed upper end and an open lower end. The inductive coil 12 is supported by a coil support 12a made of a heat-resistant insulating material and is provided to surround the outer periphery of the reaction tube 7. To the inductive coil 12, from an AC power supply 13, alternating current (AC) power for example, with a frequency of 10 to 450 kHz and a power level of 10 to 200 kW is supplied. By an AC magnetic field generated by flowing alternating current through the inductive coil 12, inductive current flows to the heat-generator 6, causing heat-generation of the heat-generator 6 due to Joule heating. With the heat generation of the heat-generator 6, the wafers 4 held in the boat 3 are heated to a predetermined processing temperature, for example, 1500 to 2000 degrees C due to the radiant heat generated from the heat-generator 6. At this time, to prevent thermal damage, it is desirable to maintain the temperature of components below the process furnace 2, for example, at 200 degrees C or less.

A thermal-insulator 14 is provided between the reaction tube 7 and the heat-generator 6. The thermal-insulator 14 is formed in a cylindrical shape with a closed upper end and an open lower end.

Further, a temperature measurement assembly 15 for detecting the processing temperature is provided between the boat 3 holding the wafers 4 as described above and the heat-generator 6. The temperature measurement assembly 15 penetrates the manifold 11 to extend vertically up to near the upper end of the boat 3. The temperature measurement assembly 15 is electrically connected to a temperature controller (not illustrated). The temperature controller regulates the power supplied from the AC power supply 13 to the inductive coil 12 based on temperature information detected by the temperature measurement assembly 15, thereby controlling the processing temperature for the wafers 4 to a desired temperature. A heater according to the present embodiment is primarily constituted by the heat-generator 6, the inductive coil 12, the AC power supply 13, and the temperature measurement assembly 15.

Further, an outer thermal-insulation wall 16 is provided outside the inductive coil 12 to surround the reaction chamber 8. The other thermal-insulation wall 16 has, for example, a water-cooled structure to prevent the internal heat of the reaction chamber 8 from being transferred to the outside. Furthermore, a magnetic shield 17 is provided outside the outer thermal-insulation wall 16 to prevent the leakage of the magnetic field generated by the inductive coil 12 to the outside.

A first gas nozzle 18, which has a first gas supply port 18a at an upper end thereof, and others are arranged in the process furnace 2. The first gas nozzle 18 is located inside the heat-generator 6 and is vertically arranged between the accommodation region for the wafers 4 and the heat-generator 6. The first gas nozzle 18 is connected to a first gas supply pipe 19 provided to penetrate the manifold 11. A gas supply unit 21 is connected to an upstream end of the first gas supply pipe 19.

A second gas supply pipe 22 is vertically arranged outside the heat-generator 6 and between the thermal-insulator 14 and the reaction tube 7. A second gas supply port 23 is provided at a downstream end of the second gas supply pipe 22. The second gas supply pipe 22 is provided to penetrate the manifold 11. The gas supply unit 21 is connected to an upstream end of the second gas supply pipe 22.

A first exhaust port 24 is opened in a sidewall of the manifold 11 facing the first gas supply port 18a at the lower lateral side of the thermal-insulator 5, i.e., the accommodation region for the wafers 4. Further, a second exhaust port 25 is opened, between the thermal-insulator 14 and the reaction tube 7, in a construction wall of the manifold 11 on which the reaction tube 7 is mounted. Branched upstream ends of an exhaust pipe 26 are connected to the first exhaust port 24 and the second exhaust port 25, respectively. The exhaust pipe 26 is provided, in order from the upstream side, with a pressure sensor 27 serving as a pressure detector, an auto pressure controller (APC) valve 28 serving as a pressure regulator, and a vacuum pump 29 serving as a vacuum exhaust device. The pressure sensor 27, APC valve 28, and vacuum pump 29 are electrically connected to a pressure controller (not illustrated). The pressure controller feedback-controls the opening degree of the APC valve 28 based on pressure information measured by the pressure sensor 27, thereby controlling the internal pressure of the reaction chamber 8 to reach a predetermined pressure.

Further, by providing the second exhaust port 25 as described above, a purge gas, which is an inert gas such as nitrogen supplied from the second gas supply port 23 into the reaction chamber 8, flows between the reaction tube 7 and the thermal-insulator 14 for purging, and is then exhausted from the second exhaust port 25.

Furthermore, the boat 3 is able to be loaded into the reaction chamber 8 (i.e., boat loading) and to be unloaded (i.e., boat unloading) therefrom by a lifting mechanism (not illustrated). When the boat 3 is loaded into the reaction chamber 8, an opening of the process furnace 2, i.e., a furnace opening, is airtightly closed by a sealing cap 31 via a sealing member such as an O-ring. Further, the thermal-insulator 5 may be rotatably supported by a boat supporting mechanism 30 provided at the sealing cap 31.

A controller 50 controls each component of the substrate processing apparatus 1 and includes a central processing unit (CPU) 51, a main memory 52, and an auxiliary memory 53. The auxiliary memory 53 stores recipe information that defines a series of operations for causing the substrate processing apparatus 1 to perform annealing treatment and others and a program executed by the CPU 51 to actually control the substrate processing apparatus 1 based on the recipe information. The auxiliary memory 53 may include a recording medium such as an optical disk.

Next, details of the temperature measurement assembly 15 will be described with reference to FIGS. 2 to 4. The temperature measurement assembly 15 includes a thermocouple 32, a first protective tube 33, a second protective tube 34, a sleeve 35, a first insulating tube 37, and a second insulating tube 38. The temperature measurement assembly 15 may include a seal 36 and a T-joint 39 serving as a purge gas supplier. In addition, a structure composed of the thermocouple 32, first protective tube 33, sleeve 35, seal 36, first insulating tube 37, and second insulating tube 38 is referred to as "thermocouple unit", distinct from the temperature measurement assembly 15.

The thermocouple 32 is a temperature sensor that measures the temperature, and is made of, for example, tungsten-rhenium or iridium-rhodium. To prevent degradation due to oxidation, it is desirable to operate the thermocouple in a vacuum, an inert atmosphere, or hydrogen atmosphere when used at high temperatures. The thermocouple includes a pair of wires, i.e., a positive (+) wire and a negative (-) wire, which extend along the central axis of the temperature measurement assembly 15. FIG. 2 illustrates only one wire due to drawing constraints. The pair of wires may be twisted together near a junction (in other words, a temperature measurement point) at the tip of the thermocouple 32 to protect the junction from mechanical loads. The pair of wires of the thermocouple 32 may be connected to a corresponding pair of compensation conductive wires 32a outside the process furnace 2 which is at a sufficiently low temperature. The wires and compensation conductive wires are collectively referred to as "conductive wires".

The first protective tube 33 is formed in a cylindrical shape with a closed upper end and an open lower end and covers at least a portion of the thermocouple 32 inserted into the process furnace 2. In other words, the insulating tubes are inserted through the first protective tube 33 from the lower end (first end). The first protective tube 33 may be made of, for example, a high-melting point metal such as tantalum (Ta), molybdenum (Mo), or iridium (Ir). Since these metals may oxidize at high temperatures, it is desirable to use them in a vacuum or inert atmosphere. The upper end (second end) of the first protective tube 33 may be closed by welding a lid to a cylindrical portion of the first protective tube 33, the lid being made of the same high-melting point metal as the cylindrical portion or being weldable to the cylindrical portion. The first protective tube 33 has one or a plurality of first release holes 33a that communicates the inside with the outside at a height between the upper end of the first protective tube 33 and the tip of the thermocouple 32.

The second protective tube 34 is formed in a cylindrical shape with a closed upper end and an open lower end and is mounted to an installation port from the furnace inside to cover at least a portion of the first protective tube 33 inserted into the process furnace 2. A material of the second protective tube 34 is appropriately selected from among various high-temperature ceramics and metal materials depending on a condition such as the processing temperature. Examples of the material include graphite, carbides such as tantalum carbide (TaC), titanium carbide (TiC), and SiC, nitrides such as boron nitride (BN) and aluminum nitride (AlN), and oxides such as aluminum oxide (Al₂O₃) and magnesium oxide (MgO). The second protective tube 34 has one or a plurality of second release holes 34a that communicates the inside with the outside at a lower position within the process furnace 2. The second protective tube 34 may have a smaller outer diameter at a portion thereof inserted into an installation port 41 to be described later than that of the remaining portion.

The sleeve 35 is formed in a cylindrical shape using a metal, and is airtightly connected at an upper end thereof to the lower end of the first protective tube 33, while being airtightly installed to the installation port 41 from the outside of the furnace. Specifically, the sleeve 35 has a central hole with a stepped change in inner diameter. After the first protective tube 33 is inserted to the larger diameter side of the central hole, the upper end of the sleeve 35 and a side surface of the first protective tube 33 are connected by welding or brazing. On the other hand, the smaller diameter side of the center hole, i.e., the side opposite to where the first protective tube 33 is connected, is sealed by the seal 36 while drawing out the wires of the thermocouple 32 or the compensation conductive wires 32a. The seal 36 is made of, for example, an electrically insulating material with low gas permeability, such as glass, cement, heat-resistant adhesive, or synthetic resin. In this example, the wires of the thermocouple 32 and the compensation conductive wires 32a are connected within the seal 36. The sleeve 35 also has a side surface with a stepped change in outer diameter and a hole 35a, which is formed in the side surface and serves as a second flow path that communicates the inside with the outside. At least a portion of the side surface of the sleeve 35 may be mirror-polished to improve the sealing property with an O-ring to be described later.

The first insulating tube 37 is formed in an elongated cylindrical rod shape with two through-holes 37a arranged along the central axis of the temperature measurement assembly, and is mainly arranged outside the process furnace 2. The pair of wires of the thermocouple 32 are respectively inserted through the two through-holes 37a. The first insulating tube 37 is made of, for example, a heat-resistant insulating material such as Al₂O₃, zirconium oxide (ZrO₂), quartz, and other ceramics, which electrically insulates the wires of the thermocouple 32 from each other and from the first protective tube 33, while maintaining the upright posture of the thermocouple 32. A lower end of the first insulating tube 37 is supported by the seal 36. The first insulating tube 37 may have three or more through-holes 37a, two of which are used as the through-holes 37a.

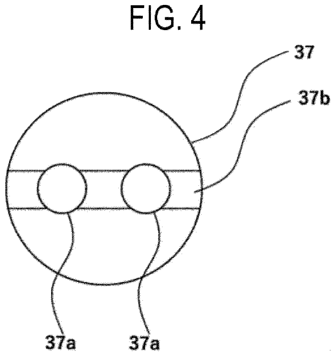

As illustrated in FIG. 4, the lower end of the first insulating tube 37 is formed with a groove 37b, which extends through the two through-holes 37a in a direction perpendicular to the central axis. The groove 37b functions as a third flow path to guide a purge gas to be described later into the two through-holes 37a.

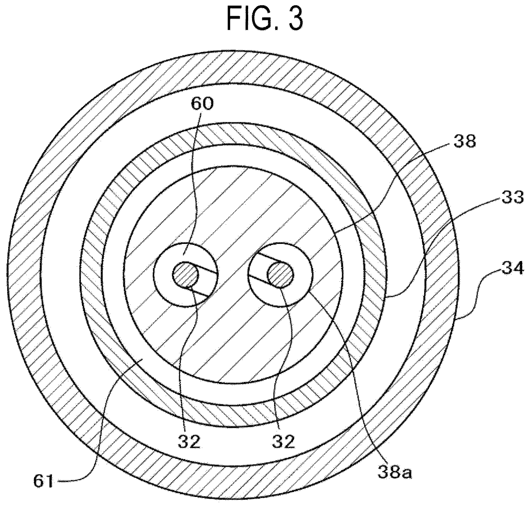

As illustrated in FIG. 3, the second insulating tube 38 is formed in a cylindrical rod shape with two through-holes 38a arranged along the central axis of the temperature measurement assembly, and is mainly arranged in a portion of the thermocouple 32 within the process furnace 2. The second insulating tube 38 may be composed of a plurality of insulating tube beads made of, for example, a heat-resistant insulating material such as MgO or hafnia (HfO₂). The insulating tube beads are short insulating tubes, each having a length of approximately 3 to 5 mm, for example, and are stacked in multiple stages on the first insulating tube 37.

The pair of wires of the thermocouple 32 are respectively inserted through the through-holes 38a. In addition, the wires of the thermocouple 32 are similarly inserted through the first insulating tube 37. This structure of the thermocouple unit is referred to as "insulating tube type". A gap is provided between the first insulating tube 37 and the second insulating tube 38 to allow for easy insertion thereof into the first protective tube 33 and to accommodate differences in thermal expansion.

As illustrated in FIG. 2, the thermocouple unit is mounted to the installation port 41 provided to vertically penetrate the seal cap 31. The installation port 41 is formed in a cylindrical shape using a metal to extend vertically downward, and the sleeve 35 is loosely fitted and inserted into the installation port 41 from a lower end outside the process furnace 2. The installation port 41 further includes an O-ring 41a and a nut (not illustrated) for pressing the O-ring 41a against the sleeve 35 and the installation port 41. By tightening the nut, the thermocouple unit is secured and a vacuum seal is achieved. In addition, a ferrule (not illustrated) may be interposed between the nut and the O-ring 41a.

The second protective tube 34 is loosely fitted and mounted into the installation port 41 from an upper end inside the process furnace 2. The second protective tube 34 is separate from the thermocouple unit and may be replaced independently of the thermocouple unit. Typically, the second protective tube 34 is installed in the reaction chamber 8 when assembling the process furnace 2. In other words, the second protective tube 34 may be provided by separately forming a lower end portion (adapter) 34b, which is mounted to the installation port 41, and the remaining cylindrical portion, and then combining them. In that case, the adapter 34b may have an enlarged diameter portion to obtain the intensity of connection with the cylindrical portion, and the enlarged diameter portion may be partially cut-out to avoid interference with the thermal-insulator 5 or the heat-generator 6.

The T-joint 39 has a metallic cylindrical portion, which is detachably attached to the outer periphery of the sleeve 35, and is mounted from the lower end side of the sleeve 35. The cylindrical portion has an inner peripheral surface with a stepped change in inner diameter that corresponds to a change in the outer shape of the sleeve 35. The mounting position of the loosely fitted sleeve 35 is determined as the stepped inner peripheral surface of the T-joint 39 restricts the entry of the stepped outer peripheral surface of the sleeve 35. The T-joint 39 includes an O-ring 39a that is a first seal, an O-ring 39b that is a second seal, and two nuts that press the O-rings 39a and 39b against the sleeve 35 and the T-joint 39, respectively. This structure may be similar to the installation port 41. The T-joint 39 further has a hole in the airtight section between the O-rings 39a and 39b, which communicates with the hole 35a in the side surface of the sleeve 35, and a purge gas introduction pipe 39c is connected to this hole. At least one of the communication hole and the purge gas introduction pipe 39c constitutes a first flow path.

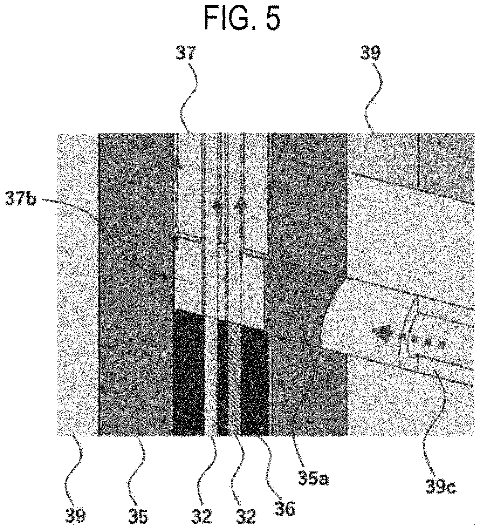

As illustrated in the enlarged view of FIG. 5, it is desirable that the first flow path of the T-joint 39 is open to face the hole 35a (i.e., a second flow path) of the sleeve 35. Further, it is desirable that the hole 35a is open on the extension of the groove 37, in other words, in the same direction as the arrangement direction of the two through-holes 37a, so as to face the groove 37b of the first insulating tube 37. Further, it is desirable for the depth of the groove 37b to be set so that an upper end of the groove 37b is aligned with an upper end of the hole 35a. Further, it is desirable that the lower end of the first insulating tube 37 is set to be aligned with or be located below the hole 35a.

Hereinafter, purge using an inert gas in the temperature measurement assembly 15 will be described.

A purge gas source (not illustrated), which supplies an inert gas such as Ar or N₂, is connected to the purge gas introduction pipe 39c. The purge gas source continuously supplies a constant amount of purge gas to the purge gas introduction pipe 39c, at least while the process furnace 2 is at a high temperature. The purge gas introduced from the purge gas introduction pipe 39c flows to the interior of the T-joint 39 through the first flow path of the T-joint 39, then passes through the hole 35a of the sleeve 35, and flows into the sleeve 35.

As described above, the first insulating tube 37 is provided with the groove (i.e. notch) 37b, into which the purge gas flows. Since a lower portion of the sleeve 35 below the first insulating tube 37 is sealed with the seal 36, the purge gas that has flowed into the sleeve 35 flows upward through a gap between the first insulating tube 37 and the sleeve 35 or the first protective tube 33 as well as a gap between the through-hole 37a and the wire. This allows the purge gas supplied from the purge gas introduction pipe 39c (i.e., the first flow path) to purge both a first space 60 between the two wires and the two through-holes and a second space 61 between the first insulating tube 37 and the first protective tube 33.

The through-holes 37a and 38a are continuous at a transition location from the first insulating tube 37 to the second insulating tube 38, allowing the purge gas to flow through the through-hole 38a. Even if the gas leaks from seams of the plurality of insulating tube beads, some of the purge gas may flow through the through-hole 38a to the upper end of the second insulating tube 38. This gas then merges with the purge gas that has flowed between the outside of the second insulating tube 38 and the first protective tube 33, passing through the tip of the thermocouple 32. There is a concern that if the purge gas is at a low temperature at this time, the temperature detected by the thermocouple 32 might be lower than the actual temperature. However, in the present embodiment, as the purge gas rises through a section of the first insulating tube 37 and the second insulating tube 38, it may be heated to a temperature close to the internal temperature of the reaction chamber 8 by heat transfer from the first protective tube 33, the first insulating tube 37, and the second insulating tube 38. Furthermore, in the reaction chamber 8 at the temperature of 1500 degrees C or more, heat radiation becomes the dominant mode of heat transfer over heat conduction or heat convection. Therefore, sufficient thermal responsiveness may be achieved even if the first protective tube 33 is not in contact with the second protective tube 34.

As described above, the first release hole 33a is open near the tip of the first protective tube 33, through which the inert gas that has flowed from below the thermocouple 32 escapes. In addition, in the present embodiment, it has been described that the tip of the first protective tube 33 is sealed and the first release hole 33a is open in the side surface of the first protective tube 33. A seal at the tip of the first protective tube 33 may be open, or there may be a hole in the seal to allow the purge gas to escape.

The purge gas escaping to the outside of the first protective tube 33 flows downward between the first protective tube 33 and the second protective tube 34. The second release hole 34a is open in a lower portion of the second protective tube 34, through which the purge gas is released into the reaction chamber 8. The second release hole 34a is located closer to the first exhaust port 24 than the wafers 4 and is open at the downstream side of the process gas flowing through the reaction chamber 8, thereby limiting the impact of the purge gas on the wafers 4. Further, the temperature of the wafer 4 passing near the second release hole 34a during the loading and unloading of the boat 3 is sufficiently lower than the temperature used to thermally process the wafer 4.

According to the present embodiment, one or more effects as described below are obtained.

By enabling the introduction of the inert gas from the T-joint, it is possible to flow the inert gas from the holes in the sleeve into the first protective tube, and also to facilitate the flow of the inert gas through the through-holes where the thermocouple wires pass due to the cuts (grooves) in the insulating tube. Furthermore, the inert gas that has flowed up to the upper end of the first protective tube flows between the first protective tube and the second protective tube and is discharged into the furnace from the release hole of the second protective tube.

With such a non-sealed structure, the internal pressure of the first protective tube does not increase during high temperatures. As a result, there is no stress on the seal, and degradation of the seal is minimized.

There is a sheath thermocouple that is usable in a high-temperature environment. The sheath thermocouple has a structure in which a thermocouple and an insulator are inserted into a metallic sheath tube, the interior of the sheath tube is filled with an inert gas, and a sealing end of the sheath tube is sealed to isolate the thermocouple from an oxidizing atmosphere. In this structure of the sheath thermocouple, especially when the sheath tube is covered with a protective tube, impurities contained in the protective tube are released at high temperatures, and these released gases remain trapped in the protective tube as there is no escape route. Prolonged exposure to these released gases may potentially degrade the sheath tube over time, particularly causing degradation of the sheath tube. Moreover, evaporation or gas release from the sheath tube itself may lead to degradation of the thermocouple or protective pipe, and potentially lead to the contamination of the process chamber. In particular, the presence of oxygen components causes oxidation of materials, and metallic components affect the electromotive force of thermocouple wires.

In the present embodiment, a continuous flow of inert gas is maintained within the first protective tube, which serves to push oxygen and impurities that cause degradation of the thermocouple wires and protective tubes. Since the through-holes where the thermocouple wires pass are forcibly purged, the atmosphere in contact with the surface of the thermocouple wires is maintained constantly under a refreshed inert gas atmosphere, effectively preventing degradation of the thermocouple.

Further, even if impurities precipitate or evaporate from the second protective tube, they are pushed away by the inert gas, which may prevent degradation of the thermocouple and the first protective tube. Further, even if the seal is broken, incoming air is diluted with the inert gas, which may prevent degradation of the thermocouple within the first protective tube.

In the present embodiment, the thermocouple unit is mounted to the installation port using a robust sleeve rather than a protective tube. This ensures that even if a significant force is applied from the purge gas introduction pipe or others, the protective tube itself is not subjected to stress, thereby preventing damage. Further, sealing between the installation port and the sleeve, which is made of a metal other than a heat-resistant material such as graphite, allows for easily achieving high airtightness.

Further, since the second protective tube is designed to be separable, if the thermocouple was broken, only the thermocouple unit itself could be replaced, which is economical. Further, separating the purge gas supplier from the elongated thermocouple unit allows for easier replacement of the thermocouple unit.

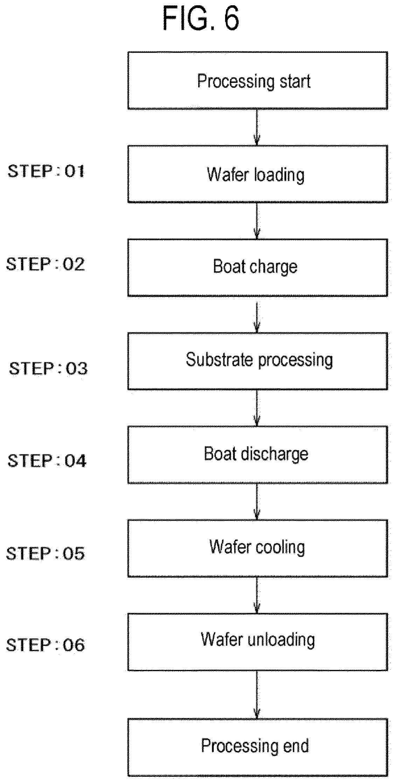

Next, substrate processing using the above-described substrate processing apparatus 1 will be described with reference to the flowchart of FIG. 6. In this processing, as a step in the manufacture of semiconductor devices, the wafer 4 made of SiC is annealed in the reaction chamber 8 under an argon (Ar) atmosphere. Further, the term "processing temperature" herein refers to the temperature of the wafer 4 or the temperature of the reaction chamber 8, and the term "processing pressure" refers to the internal pressure of the reaction chamber 8. Furthermore, in the following description, the operation of each component constituting the substrate processing apparatus 1 is controlled by the controller 50.

First, the plurality of wafers 4 are loaded (i.e., charged) into the boat 3 at a lowered position outside the reaction chamber 8 (STEP: 01).

Next, the boat 3 is raised and introduced into the reaction chamber 8 to load (prepare) the wafer 4. Further, the lower opening of the reaction tube 7 is closed (i.e., sealed) by the seal cap 31. The reaction chamber 8 is then evacuated by the vacuum pump 29, followed by supplying an Ar gas from the gas supply unit 21 and adjusting to a predetermined pressure by the APC valve 28. At this time, a N₂ gas is supplied into the thermocouple unit through the purge gas introduction pipe 39c. Then, the AC power applied to the inductive coil 12 is adjusted based on temperature information detected by the thermocouple 32 to heat the wafer 4 to a predetermined processing temperature at a predetermined heating rate (STEP: 02).

Subsequently, the wafer 4 is exposed to an Ar atmosphere at a predetermined temperature and pressure for a predetermined time. This activates ion-implanted impurities or removes oxygen from the wafer surface, resulting in the formation of an annealed wafer (STEP: 03).

A processing condition when activating annealing for the wafer 4 is exemplified as follows, for example: Processing temperature (wafer temperature): 1500 to 1900 degrees C, Processing pressure (internal pressure of the process chamber): 1 Pa to normal pressure, Ar gas flow rate: 1 sccm to 5 SLM, N₂ gas flow rate: 1 sccm to 5 SLM. Each of these processing parameters is set within each range thereof to ensure the proper progress of film formation. In addition, the notation of a numerical range such as "1500 to 1900 degrees C" as described above refers that both the lower and upper limits are included in that range. For example, " 1500 to 1900 degrees C" refers to "1500 degrees C or more and 1900 degrees C or less". This applies similarly to other numerical ranges.

Next, the power supplied to the inductive coil 12 is adjusted to lower the temperature of the wafer 4 to a predetermined temperature, and the APC valve 28 is closed to return the internal pressure of the reaction chamber 8 to atmospheric pressure. After that, the seal cap 31 is lowered, and the boat 3 is discharged (i.e., unloaded) from the reaction tube 7 (STEP: 04).

Subsequently, after the discharge of the boat 3, the wafer 4 is further cooled until the wafer 4 reaches a temperature suitable for transfer (STEP: 05).

Finally, the processed wafer 4 is transferred from the boat 3 to a cassette by a mobile loader (not illustrated) (STEP: 06).

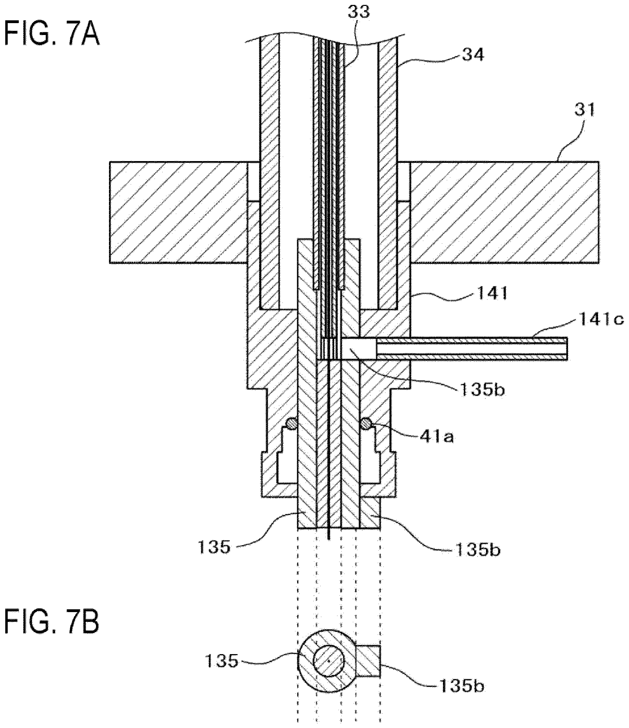

A temperature measurement assembly according to a modification will be described with reference to FIGS. 7A and 7B. This modification differs from the previous embodiment in that the installation port 41 and the T-joint 39 are integrated and the adapter 34b is eliminated. An installation port 141 in this modification is formed in a cylindrical shape with an inner diameter that changes in two stages. The larger diameter side is connected to the seal cap 31, and the smaller diameter side is provided with the O-ring 41a and a nut (not illustrated) for pressing the O-ring 41a against a sleeve 135 and the installation port 141. The inner diameter on the larger diameter side corresponds to that of the second protective tube 34, while the inner diameter on the smaller diameter side corresponds to the outer diameter of the sleeve 135. The installation port has a hole formed in the inner side surface thereof on the smaller diameter to communicate with a hole 135a formed in the side surface of the sleeve 135, and a purge gas introduction pipe 141c, which corresponds to the purge gas introduction pipe 39c, is connected to the hole of the installation port.

The sleeve 135 is formed in a tubular shape with a smaller outer diameter than the outer diameter of the seal cap 31 and has a stepped protrusion 135b at a lower end thereof. The mounting position of the sleeve 135, which is loosely fitted into an end of the installation port 141 from the smaller diameter side, is determined by bringing the stepped protrusion into contact with a nut end surface of the installation port 141. Therefore, the sleeve 135 does not need a stepped change in outer diameter. Other than that, it functions similarly to the sleeve 35. The stepped protrusion 135b is provided in the same direction as the hole 135a when viewed from the central axis of the sleeve 135, aiding in aligning the hole 135a with the purge gas introduction pipe 141c.

In the above-described embodiments, an example of forming a film using a batch-type substrate processing apparatus capable of processing multiple substrates at once has been described. The present disclosure is not limited to the above-described embodiments, and for example, may be suitably applied even when forming a film using a single wafer type substrate processing apparatus capable of processing one or several substrates at once. Further, in the above-described embodiments, an example of forming a film using a substrate processing apparatus equipped with a hot wall type process furnace has been described. The present disclosure is not limited to the above-described embodiments, and may also be suitably applied when forming a film using a substrate processing apparatus equipped with a cold wall type process furnace.

Even when using such a substrate processing apparatus, it is possible to perform each process using the same process procedures and process conditions as in the above-described embodiments and modifications, and to achieve the same effects as in the above-described embodiments and modifications.

According to the present disclosure, stable temperature measurement is possible for a long period of time in a high-temperature environment.

While certain embodiments are described, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A temperature measurement assembly (15) comprising:
(a) an insulating tube (37) with two through-holes (37a) through which two conductive wires (32a) of a temperature sensor (32) are respectively inserted;
(b) a first protective tube (33), through which the insulating tube (37) is inserted inwardly from a first end of the first protective tube (33);
(c) a cylindrical sleeve (35, 135) airtightly connected to the first end of the first protective tube (33) and airtightly installed to an installation port (41, 141) from an outside of a furnace (2); and
(d) a second protective tube (34) mounted to the installation port (41, 141) from an inside of the furnace (2) and covering the entire first protective tube (33) on the inside of the furnace (2).

2. The temperature measurement assembly (15) of claim 1, further comprising a joint (39) mounted to an outer periphery of the sleeve (35, 135) and providing a first flow path communicating with a side portion of the sleeve (35, 135),
wherein the sleeve (35, 135) includes a second flow path communicating the first flow path with an inside of the sleeve (35, 135),
wherein the insulating tube (37) includes a third flow path communicating the second flow path with the two through-holes (37a), and
wherein a purge gas supplied from the first flow path purges both a first space (60) between the two conductive wires (32a) and the two through-holes (37a) and a second space (61) between the insulating tube (37) and the first protective tube (33).

3. The temperature measurement assembly (15) of claim 1, wherein the sleeve (35, 135) includes a flow path communicating a purge gas to an inside of the sleeve (35, 135),
wherein the first protective tube (33) includes a first release hole (33a) at a second end opposite to the first end, which communicates an inside of the first protective tube (33) with an outside of the first protective tube (33), and
wherein the purge gas flows through the first protective tube (33) from the first end toward the second end, and thereafter, flows through a gap between the first protective tube (33) and the second protective tube (34) from the second end toward the first end.

4. The temperature measurement assembly (15) of claim 2, wherein the second protective tube (34) includes a second release hole (34a) on the inside of the furnace (2) near the installation port (41, 141) communicating an inside of the second protective tube (34) with an outside of the second protective tube (34), and
wherein the purge gas is released into a furnace (2).

5. The temperature measurement assembly (15) of claim 1, wherein the conductive wires (32a) are drawn out at an opening on a side of the sleeve (35, 135) opposite to where the first protective tube (33) is connected, through which the conductive wires (32a) are drawn out, and the opening is sealed by a seal (36).

6. The temperature measurement assembly (15) of claim 2, wherein the third flow path is formed through the insulating tube (37) from a side facing the second flow path to an opposite side.

7. The temperature measurement assembly (15) of claim 6, wherein one end of the insulating tube (37) is disposed at a position corresponding to the second flow path of the sleeve (35, 135), the third flow path is formed at the one end of the insulating tube (37) as a groove (37b) penetrating the two through-holes (37a), and the groove (37b) faces the second flow path.

8. The temperature measurement assembly (15) of claim 2, further comprising:
a first seal (39a, 41a) pressed between an outer periphery of the sleeve (35, 135) and the joint (39) to seal a gap therebetween at a position closer to the first protective tube (33) than the first flow path; and
a second seal (39b, 41b) pressed between the outer periphery of the sleeve (35, 135) and the joint (39) to seal the gap therebetween at a position farther from the first protective tube (33) than the first flow path.

9. The temperature measurement assembly (15) of claim 2, wherein the sleeve (35, 135) is arranged such that a central axis of the sleeve (35, 135) is aligned with a central axis of the first protective tube (33), and the outer diameter of the sleeve (35, 135) at a position closer to the first protective tube (33) is formed larger than the outer diameter of the sleeve (35, 135) at a position farther from the first protective tube (33), and the joint (39) has an inner diameter change corresponding to a change in the outer diameter of the sleeve (35, 135).

10. The temperature measurement assembly (15) of claim 2, wherein the outer diameter of the sleeve (35, 135) at a position closer to the first protective tube (33) is formed larger than the outer diameter of the sleeve (35, 135) at a position farther from the first protective tube (33), and the joint (39) is detachably mounted to the sleeve (35, 135) and has an inner diameter change corresponding to a change in the outer diameter of the sleeve (35, 135).

11. The temperature measurement assembly (15) of claim 3, further comprising a plurality of insulating tube beads (38) with the two through-holes (38a), through which the two conductive wires (32a) are inserted, closer to the second end than the insulating tube (37).

12. A substrate processing apparatus (1) comprising:
a process furnace (2) configured to thermal-process a substrate (4);
the temperature measurement assembly (15) of claim 1; and
the installation port (41, 141) configured to mount the temperature measurement assembly (15) vertically that measures a temperature of an inside of the process furnace (2).

13. The substrate processing apparatus (1) of claim 12, wherein the process furnace (2) includes:
an airtight container (7, 11);
a cylindrical heat-generator (6) disposed inside the container (7, 11) to surround the substrate (4) and configured to be inductively heated; and
a thermal-insulator (5) disposed between the container (7, 11) and the heat-generator (6), and
wherein the temperature measurement assembly (15) is disposed to extend vertically in a space between the heat-generator (6) and the substrate (4).

14. A method of processing a substrate (4) comprising:
preparing the substrate (4) in a process furnace (2) where the temperature measurement assembly (15) of claim 1 is mounted vertically such that a second end opposite to the first end is upward; and
heating the process furnace (2) while measuring a temperature of an inside of the process furnace (2) to thermal-process the substrate (4).

15. A method of manufacturing a semiconductor device, comprising the method of processing the substrate (4) of claim 14.
